Europäisches Patentamt

(19) European Patent Office

Office européen des brevets

(11) Publication number: 0 269 206 B1

# EUROPEAN PATENT SPECIFICATION

(45) Date of publication of patent specification: 02.05.91  (51) Int. Cl.⁵: **H05K 9/00**

(21) Application number: 87307628.5

(22) Date of filing: 28.08.87

(54) A door seal for excluding electromagnetic interference.

(30) Priority: 30.08.86 GB 8621034

(43) Date of publication of application:
01.06.88 Bulletin 88/22

(45) Publication of the grant of the patent:
02.05.91 Bulletin 91/18

(84) Designated Contracting States:
BE DE ES FR GR IT NL SE

(56) References cited:
AT-B- 52 855
FR-A- 2 583 099

(73) Proprietor: THE MARCONI COMPANY LIMITED
The Grove Warren Lane
Stanmore Middlesex HA7 4LY(GB)

(72) Inventor: Henderson, William Iain Mackie
91 Edge Hill Darras Hall
Ponteland Northumbeland NE20 9JQ(GB)
Inventor: Morrison, David John
5 Hobart Whitley Bay
Tyne & Wear NE26 3TA(GB)
Inventor: Smith, Moira
19 Foxhills Covert
Wickam Newcastle NE16 5TN(GB)
Inventor: Thornley, David John
4 Sunny Brae Ryton
Tyne & Wear NE40 4JB(GB)
Inventor: Leask, Samuel Hall
27 Walworth Avenue
Narsden Estate South Shields NE34 7EP(GB)
Inventor: Matthews, Christopher F.
Dere Hollow
Riding Hill Northumberland NE44 5DQ(GB)

(74) Representative: Hyden, Martin Douglas
GEC Patent Department GEC-Marconi Research Centre West Hanningfield Road
Great Baddow Essex CM2 8HN(GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a door seal for excluding electromagnetic interference. It arose in the design of a container or shelter for transportable electronic equipment.

In one known construction the rim of a door has faces which extend around the edge of the door and which are inclined with respect to a centre plane of the door. When the door is closed these faces co-operate with corresponding faces on a door frame to define a tortuous channel which very severely attenuates any RF radiation passing along it.

The degree of attenuation depends on the length and tortuousness of the aforementioned channel and so it is desirable to make the inclined faces as steep as possible with respect to the centre plane of the door. However, because the door hinge is normally offset from the centre plane, the inclined faces on the door have a component of movement in the direction of that plane during an initial opening movement (or a final closing movement) of the door. There is a limit to the allowable inclination of the faces permissable whilst still allowing the door to open and close. This limit varies within increasing distance from the hinge because the aforementioned component of movement is greater for faces closer to the hinge and less for faces farther from the hinge. It is therefore possible to make the faces farther from the hinge steeper than those that are closer.

The invention accordingly provides a door assembly comprising a door frame defining an opening, and a door connected to the frame by a hinge allowing for movement of the door between closed and open positions, the door having first inclined faces which face away from the hinge and second faces which face towards the hinge, these first and second faces on the door co-operating with respective second and first faces on the door frame when the door is closed to form a tortuous passage which inhibits leakage of electromagnetic interference, the door hinge being offset from a centre plane passing through the door frame so that, as the door is opened, the resulting movement of each of the first faces on the door has a component in the direction of the said centre plane, the said first faces on the door making an increasing angle with respect to the centre plane with increasing distance from the hinge.

Faces directed away from the hinge on the side of the door remote from the hinge, being the farthest from the hinge, are preferably inclined more steeply than those on the side closest to the hinge.

In a preferred form of the invention the said inclined faces on the door are defined by extruded members forming a rim which supports a central door panel. It is desirable, for economy, to use the same type of extrusion on all sides of the door. For this reason the extrusion is preferably shaped so that, on the side of the door closest to the hinge, the "second" faces (i.e. those directed towards the hinge) are the steepest. This means that the corresponding faces, directed away from the hinge on the side of the door remote from the hinge, are also the steepest.

The door frame or surround is preferably also formed from extruded members with faces inclined at similar angles to those of the door rim so as to co-operate therewith to form the aforementioned tortuous channel.

One way in which the invention may be performed will now be described by way of example with reference to the accompanying drawings in which:-

Fig. 1 is a horizontal cross section through a door and door frame forming part of a shelter for electronic equipment and constructed in accordance with the invention; and

Fig. 2 is a detailed view of a flexible seal and associated parts also shown in less detail in figure 1.

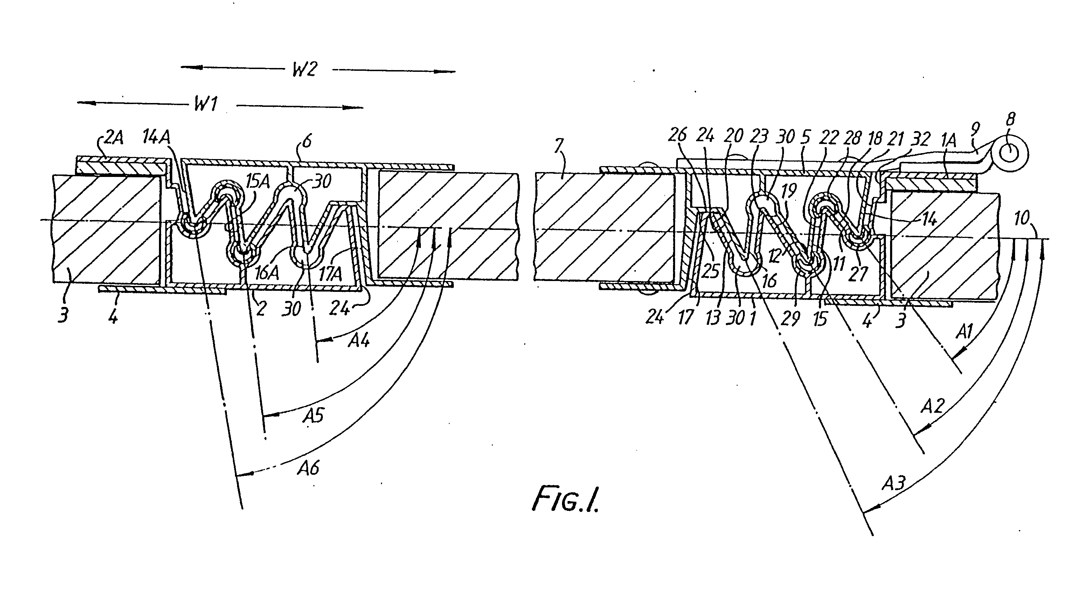

The illustrated door assembly comprises a door-frame formed from four lengths of extruded aluminium, all having the same cross section. Only the upright lengths 1 and 2 are illustrated and these are attached to wall panels 3 whose edges are received in channels defined between flange 1A and securing strip 4 on the right hand side of figure 1; and between flange 2A and securing strip 4 on the left hand side of figure 1.

The door-frame receives a door formed by a rim and a door panel. The door-rim is formed from four lengths of extruded aluminium, all having the same cross sectional shape. Only the upright lengths 5 and 6 of the door-rim are illustrated. As can be seen from figure 1, these define channels into which the door panel 7 fits.

The door is hinged to the frame, about an axis 8, by a hinge 9 which is displaced to one side of a plane 10 passing centrally through the door panel 7.

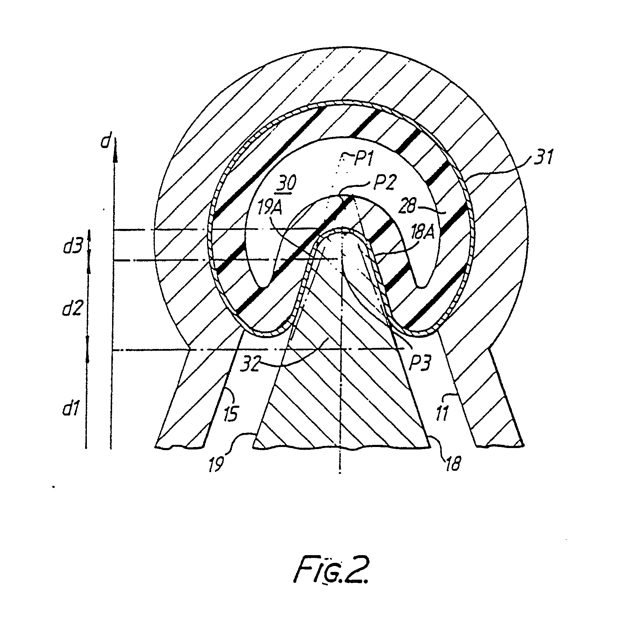

The door-rim upright 5 defines three "first" faces 11,12,13 directed away from the hinge and four "second" faces 14,15,16,17 directed towards the hinge. These co-operate with "second" faces 18,19,20 and "first" faces 21,22,23,24 respectively on the door-frame upright 1 to define a tortuous path between door and frame. This attenuates RF energy which might otherwise leak pass abutting faces 25 and 26 when the door is closed. Seals 27,28,29 are located on cylindrical sockets 30 defined between faces 18,21; 11,15 and 19,22. Seal 27 is made of rubber tubing and provides weather proofing. Seals 28 and 29 are of similar construction but are covered in conductive braid 31 (Fig 2). The conductive braid 31 provides the necessary electrical connection between the door-rim and the door-frame to provide a seal against electromagnetic interference.

There are thus three features by which the seal against electromagnetic interference is produced:

1. the abutting faces 24 and 25;

2. the braid covered rubber seals 28 and 29; and

3. the tortuous passage between door rim and door frame.

The axis 8 about which the door hinges is displaced from the centre plane 10 and this displacement causes movement of the faces 11,12,13 as the door opens to have a component parallel to the plane 10 during a period before the noses on the door clear the noses on the frame. This imposes a limitation on the steepness of the slope of the faces 11,12 and 13 permissable without causing them to foul against corresponding faces 18,19 and 20.

Because the "first" faces 11,12 and 13 are progressively more distant from the axis 8 of the hinge, the displacement from the centre plane of the door is progressively less significant and the movement has a progressively smaller component in the direction of the centre plane 10. Thus the "first" faces 11,12 and 13 can be made progressively steeper and define angles A1,A2,A3 with the centre plane 10 as illustrated in figure 1. The displacement of the hinge causes the "second" faces 14,15,16 and 17 of the door to tend to move away from their opposing "first" faces 21,22,23 and 24 of the door frame so that they can be made relatively steep and, as can be seen from the drawing, they each define an angle at least as great as A3.

The upright 6 remote from the hinge is formed from the same extrusion dye as that from which the upright 5 is made and has an identical cross section. The faces on the upright 6 are denoted by reference numerals identical to those used for corresponding faces of the upright 5 but with addition of the suffix letter A. It will be noted from the drawing that the relatively steep faces 14A,15A,16A and 17A face away from the hinge axis 8 and that this is appropriate since their distance from the hinge is sufficient to make a steep angle permissable without risk of fouling on the corresponding faces of the door frame member 2 (which is identical to the frame member 1).

By use of the increasing angles A1,A2,A3 and of the even greater angles A4,A5,A6; the maximum length and tortuousness of the passage is obtained; and the maximum number of angled lengths of the tortuous passage can be fitted into the width W1 of the extruded members 2 and into the width W2 of the extruded member 6. This in turn allows up to four RF seals to be used (although only two are employed in the illustrated embodiment) whilst still leaving space for a weather seal 27. This latter feature is important since it avoids the need for a separate seal around an edge such as that shown at 32 of the frame as has previously been needed.

It was found during initial environmental tests that oxidation of the metal braid 31 could cause an imperfect electrical contact. This difficulty was overcome by shaping the noses 32 (defined between faces 18,19 and 12,15) in a manner as is apparent from figure 2; from which it can be seen that the inclined faces 18,19 have portions 18A,19A in an end region d2 of the nose which converge towards a point P1 less rapidly with respect to distance d along the nose than in a major region d1, where they converge towards a point P2. The extreme end of the nose, in region d3, is rounded with a circular form centred at point P3.

From figure 2 it can be seen that the region d2 of each nose enters a cylindrical socket 30 in which the corresponding seal is located so that, when the door is closed, the tip of the nose coincides with the axis of the cylindrical shape of the socket. During movement of the nose to and from the closed position it has been found that a rubbing action occurs between the metal braid 31 and the nose, this serving to wipe away any oxide film which may have formed on the co-operating surfaces. This self-cleaning action is a feature claimed in our co-pending patent application of even date.

## Claims

1. A door assembly comprising a door frame defining an opening, and a door connected to the frame by a hinge (9) allowing for movement of the door between closed and open positions, the door having first inclined faces (11,12,13) which face away from the hinge and second faces (14,15,16,17) which face towards the hinge (9), these first and second faces on the door co-operating with respective second (18,19,20) and first (21,22,23,24) faces on the door frame when the door is closed to form a tortuous passage which inhibits leakage of electromagnetic interference, characterised in that the door hinge (9) is being offset from a centre plane (10) passing through the door frame so that, as the door is opened, the resulting movement of each of the first faces on the door has a component in the direction of the said centre plane, and further characterised in that the said first faces (11,12,13) on the door make an increasing angle with respect to the centre plane with increasing distance from the hinge.

2. A door assembly according to claim 1 further characterised by a door rim having two upright members (5,6) of similar cross-section, the first faces (11,12,13) on the member closest to the hinge making larger angles with respect to the centre plane than any of the second faces (14,15,16,17) on the same member.

## Revendications

1. Ensemble de porte comportant un châssis de porte définissant une ouverture, et une porte reliée au châssis par une charnière (9) permettant un déplacement de la porte entre des positions fermée et ouverte, la porte ayant des premières faces inclinées (11, 12, 13) qui font face à l'opposé de la charnière et des deuxièmes faces (14, 15, 16, 17) qui font face à la charnière (9), ces premières et deuxièmes faces sur la porte coopérant avec des deuxièmes (18, 19, 20) et premières (21, 22, 23, 24) faces respectives sur le châssis de porte lorsque la porte est fermée afin de former un passage tortueux qui empêche une fuite d'interférence électromagnétique, caractérisé en ce que la charnière de porte (9) est décalée par rapport au plan central (10) passant par le châssis de porte de telle sorte que, lorsque la porte est ouverte, le déplacement résultant de chacune des premières faces sur la porte a une composante sensiblement parallèle au dit plan central, et caractérisé en outre en ce que les dites premières faces (11, 12, 13) sur la porte font un angle croissant par rapport au plan central avec la distance croissante depuis la charnière.

2. Ensemble de porte selon la revendication 1, caractérisé en outre par un entourage de porte ayant deux éléments verticaux (5, 6) de section similaire, les premières faces (11, 12, 13) sur l'élément le plus proche de la charnière faisant des angles plus petits par rapport au plan central que n'importe laquelle des deuxièmes faces (14, 15, 16, 17) sur le même élément.

## Ansprüche

1. Türanordnung, welche umfaßt einen eine Öffnung bestimmenden Türrahmen und eine Tür, die mit dem Rahmen verbunden ist über ein Scharnier (9), das eine Bewegung der Tür zwischen geschlossener und offener Stellung zuläßt, wobei die Tür erste Schrägflächen (11, 12, 13) besitzt, die von dem Scharnier weg gewendet sind, und zweite Flächen (14, 15, 16, 17), die dem Scharnier (9) zu gewendet sind, diese ersten und zweiten Flächen an der Tür mit jeweiligen zweiten (18, 19, 20) und ersten (21, 22, 23, 24) Flächen an den Türrahmen bei geschlossener Tür zur Bildung eines gewundenen Durchlasses zusammenwirken, der das Durchdringen von elektromagnetischer Störung verhindert, dadurch gekennzeichnet, daß das Türscharnier (9) gegen eine durch den Türrahmen hindurchlaufende Zentralebene (10) so versetzt ist, daß bei geöffneter Tür die sich ergebende Bewegung jeder ersten Fläche an der Tür eine im wesentlichen parallel zu der Zentralebene verlaufende Komponente besitzt, und weiter dadurch gekennzeichnet, daß die ersten Flächen (11, 12, 13) an der Tür einen mit zunehmendem Abstand vom Scharnier zunehmenden Winkel bezüglich der Zentralebene bilden.

2. Türanordnung nach Anspruch 1, weiter gekennzeichnet durch einen aus zwei aufrecht stehenden Elementen (5, 6) mit gleichartigem Querschnitt bestehenden Türrand, wobei die ersten Flächen (11, 12, 13) an dem Element, das dem Scharnier am nächsten liegt, kleinere Winkel bezüglich der Zentralebene bilden als irgendeine zweite Fläche (14, 15, 16 17) an dem gleichen Element.

FIG.I.

FIG.2.